# EUROPEAN PATENT APPLICATION

(11) **EP 1 908 808 A1**
(43) Date of publication of application: **09.04.2008**
(21) Application number: 07018523.6
(22) Date of filing: 20.09.2007
(51) Int. Cl.: C09J 7/02, H01L 21/78

(54) **Adhesive sheet for laser processing**

(30) Priority: 04.10.2006 JP 2006272862
(71) Applicant: Nitto Denko Corporation, Ibaraki-shi, Osaka 567-8680 (JP)
(72) Inventor: Asai, Fumiteru, Ibaraki-shi Osaka 567-8680 (JP); Shintani, Toshio, Ibaraki-shi Osaka 567-8680 (JP); Sasaki, Takatoshi, Ibaraki-shi Osaka 567-8680 (JP); Yamamoto, Akiyoshi, Ibaraki-shi Osaka 567-8680 (JP); Takahashi, Tomokazu, Ibaraki-shi Osaka 567-8680 (JP)
(74) Representative: Schaeberle, Steffen

(57) **Abstract**

An adhesive sheet for laser processing comprises an adhesive layer laminated on the surface of a base film, wherein the base film has a textured contact-reducing layer on the back side thereof. According to the adhesive sheet for laser processing of the present invention, the melting of the base film caused by the local concentration of laser beam energy at the places irradiated with the laser beam can be effectively prevented. Accordingly, the back side of the base film can be prevented from locally adhering to the processing table in the dicing apparatus, and subsequent steps, namely, drawing the base film to separate the workpiece from the adhesive layer, and individually recovering these, can be carried out easily and efficiently.

## Description

### BACKGROUND OF THE INVENTION

### 1. Field of the Invention

The present invention relates to an adhesive sheet for laser processing, and more particularly relates to an adhesive sheet for laser processing which is used for dicing a workpiece, such as a semiconductor wafer, by laser beam.

### 2. Background Information

Electrical and electronic parts have been decreasing in size and increasing in fineness as devices have become smaller, etc., recently. Accordingly, there is a need for greater fineness and precision in the cutting of various materials. In particular, in the semiconductor field, in which there is a great need for smaller size and higher density, attention in recent years has been focusing on methods for cutting semiconductor wafers with a laser beam, which causes no heat damage and allows high-precision processing.

This technique is a method for fixing a workpiece, obtained by subjecting a substrate to various circuit formation and surface processing steps, to a dicing sheet, and dicing the workpiece with a laser beam to create small chips (see JP- 2004-79746A, for example). Also, there has been proposed a dicing sheet comprising a base including a base film, and an adhesive layer formed on the surface of this base, with which the adhesive layer is cut by the laser beam without cutting the base film (see JP 2002-343747A, for example).

However, when a laser beam is used to dice a workpiece, it is extremely difficult to control the beam so that just the adhesive layer is cut and not the base film. Even if just the adhesive layer could be cut, there would still be that the back side of the base film adhered tightly and locally to the chuck table of the dicing apparatus at the places irradiated with the laser beam. Consequently, this complicates subsequent steps, namely, steps such as drawing the base film to separate the workpiece and recovering the cut pieces individually.

The present invention was conceived in light of this situation, and it is an object thereof to provide an adhesive sheet for laser processing, with which, when a semiconductor wafer or other such workpiece is cut with a laser beam, the cutting of the base film itself is kept to a minimum, the local adhesion of the base film to the processing table is prevented, and subsequent steps can be carried out easily and efficiently.

### SUMMARY OF THE INVENTION

As a result of diligent research into the phenomenon that a base film and a processing table locally adhere firmly together where irradiated with a laser beam during dicing with a laser dicing apparatus, the inventors assumed that the energy of the laser beam reaches the back side of the base film and concentrates locally, which generates heat, and this concentration of laser beam energy and the resulting generation of heat contribute to the melting of the base film material and so forth, and found specific conditions, or a combination thereof, under which this problems can be kept to a minimum, finally arrived at the present invention.

The present invention provides an adhesive sheet for laser processing, comprising an adhesive layer laminated on the surface of a base film, wherein the base film has a textured contact-reducing layer on the back side thereof.

With the adhesive sheet for laser processing of the present invention, the phenomenon of local adhesion to the processing table of a dicing apparatus caused by the local concentration of laser beam energy at the places irradiated with the laser beam can be effectively prevented on the base film back side by reducing the area of the base film back side in contact with the processing table. Therefore, subsequent steps, namely, drawing the base film to separate the workpiece from the adhesive layer, and individually recovering these, can be carried out easily and efficiently.

In particular, if the contact-reducing layer provides the outer surface on the back side of the base film with a texture having arithmetical mean deviation of the surface Ra of at least 1.0 µm, the contact area of the base film to the processing table can be effectively reduced.

Furthermore, if the base film has the transmissivity of at least 50%, deterioration of the base film itself by the laser beam can be prevented.
Also, if the base film comprises at least one layer containing a polyolefin resin, the optical transmissivity and/or the optical absorption coefficient with respect to the laser beam being used can be set relatively high, making the base film itself more resistant to processing, that is, to being cut.

In particular, if the polyolefin resin is at least one resin selected from the group consisting of polyethylene, polypropylene, polyethylene copolymer, propylene copolymer, ethylene-propylene copolymer, it is possible to significantly maximize the above effects.
Further, if the base film comprises a layer having a melting point of at least 80°C, the melting of the base film can be prevented more effectively on the base film back side, and the phenomenon of local adhesion to the processing table can be suppressed.

Also, if the base film includes at least two layers with different fracture elongation, and the layer with the greater fracture elongation is disposed adjacent to the contact-reducing layer, or if the layer with the greater fracture elongation has a fracture elongation of at least 100%, the optical transmissivity and/or the optical absorption coefficient with respect to the laser beam being used can be set relatively high, making the base film itself more resistant to being cut.
Moreover, if the contact-reducing layer is formed by sand blasting, embossing processing or surface coating, the contact-reducing layer can be easily and simply formed.

The adhesive sheet for laser processing of the present invention can be utilized in a wide range of any kinds of applications such that it is applied to semiconductor wafers (such as silicon wafer, germanium wafer, gallium arsenide wafer), circuit boards, ceramic substrates, metal substrates, substrates for light-emitting diode (e.g. semiconductor laser) and photoreceptor, substrates for MEMS (micro electro mechanical system), semiconductor packages and the like.

### BRIEF DESCRIPTION OF THE DRAWINGS

FIG. 1 is simplified cross sectional view of the adhesive sheet for laser processing of the present invention.
FIG. 2 is simplified plan view of the adhesive sheet for laser processing of the present invention.

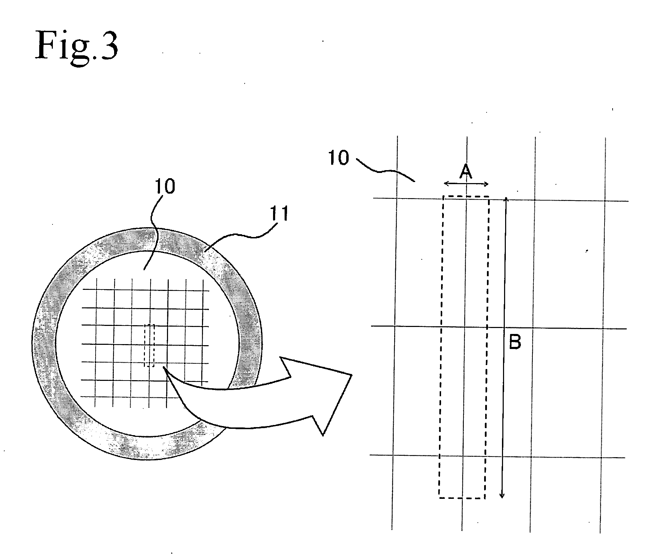

FIG. 3 is simplified schematic and magnified views of the test samples of the adhesive sheet for laser processing of the present invention to explain how to preparation of the test samples.

### DETAILED DESCRIPTION OF THE PREFERRED EMBODIMENTS

The adhesive sheet for laser processing of the present invention mainly comprises a base film having a textured contact-reducing layer on the back side thereof, and an adhesive layer disposed on the front side of this base film
The textured contact-reducing layer formed on the back side of the base film is a layer that reduces the area of the base film back side in contact with the processing table so that the base film itself will not adhere or firmly-deposit to the processing table or the like as a result of melting, etc. of the base film by irradiation with a laser beam.

The contact-reducing layer provides the outer surface of the base film back side with a texture having arithmetical mean deviation of the surface Ra of at least 1.0 µm, for example. In particular, it is preferably arithmetical mean deviation of the surface Ra of at least 1.2 µm, at least 1.3 µm, and at least 1.5 µm. These texture will make it possible to reduce the area of the base film itself in contact with the processing table, and will introduce suitable gaps between the base film itself and the processing table to allow the energy of the laser light energy from the surface side of the base film to escape to outside of the adhesive sheet for laser processing.

The contact-reducing layer may be formed, for example, as itself a part of the base film by a method well-known in the field, such as sand blasting, embossing, or surface coating the back side of the base film, that is, the side opposite where the adhesive layer is formed. Alternatively, a film with a texture on one surface may be separately formed by sand blasting, embossing, or surface coating, etc., and then integrated by being applied to the back side of the base film. The concave portions of the texture in this case may be formed by minute through holes. That is, through holes may be formed in the base film itself to form the contact-reducing layer, or a film with through holes may be formed separately from the base film and then integrated by being applied to the back side of the base film.

The contact-reducing layer can be formed using particles of materials such as an inorganic compound, a metal, an organic compound, or cnbination thereof on the back side of the base film.
Examples of these particles include, as inorganic compounds, inorganic particles of silica (fumed silica, silicic anhydride, precipitated silica, molten silica, crystalline silica, ultrafine powdered amorphous silica or the like), metallic oxides (aluminum oxide, titanium dioxide, tin II oxide, tin IV oxide, zinc oxide, calcium oxide, magnesium oxide or the like), metallic nitride (silica nitride, aluminum nitride or the like), metallic carbides (SiC or the like), metallic carbonates (potassium carbonate, sodium carbonate, calcium carbonate, magnesium carbonate or the like), metallic hydroxides (aluminum hydroxide, magnesium hydroxide or the like), barium titanate, calcium phosphate, calcium silicate, gypsum, zeolite, talc, clay, barium sulfate, mica, diatomic earth, metals (gold, silver, palladium, platinum, nickel, aluminum, cupper, refractory metal, i.e., titanium, tungsten, tantalum, or the like) and the like; as organic compounds, resin particles for forming the base film described below. Among these, the resin particles having a higher melting point of polyolefin such as polyethylene, polypropylene; polyester such as PET; thermoplastic resin such as nylon; thermoplastic polyimide; fluorine-containing polyethylene such as PTFE, ETFE, polycarbonate; polyester and the like.
The contact-reducing layer with a texture may be formed, for example, by dispersing/suspending the above-mentioned particles in a suitable solvent, using this solution to coat the back side of the base film, and drying the coating, or one of the particles may be mixed resins used as a binder discussed below, a film having a texture is formed, and thus the film is applied to the back side of the base film to integrate. Also, the contact-reducing layer may be formed, for example, the particles may be mixed with the material for forming the base film, and thus the base film with a textured contact-reducing layer on the back side thereof may be formed.

These particles can be used in a variety of shapes, such as spheres, needles, or flakes, and can have a size ranging from about 1 µm to several hundred microns in order to serve effectively functions for the contact-reducing layer. In this case, the particles can be adjusted in an amount realizing suitable texture of the above in consideration of kinds, size, etc., of the particles used therein.

The base film can be selected from among any known film with self-supporting properties. The base film is preferably in the form of a sheet with a uniform thickness, but may also be in the form of a mesh or the like. Also, the base film may be a single layer, or may have a multilayer structure of two or more layers.

Examples of the material for the base film include polymer films such as an acrylic resin, a polyurethane resin, a polynorbomene resin, a polyalkyleneglycol resin, a polyolefin resin (e.g. polystyrene and polyethylene resin), a polyimide resin, a polyester resin, a epoxy resin, a polyamide resin, a polycarbonate resin, a silicon resin, a fluorocarbon polymer; metallic sheets such as cupper, aluminum, stainless steel; non-woven clothes made of polymeric fibers such as PP, PVC, PE, PU, PS, PO, PET, synthetic fibers such as rayon, cellulose acetate, natural fibers such as cotton, silk, wool and inorganic fibers such as a glass fiber, a carbon fiber; sheets which are made of materials described above and are provided physical or optical functions by drawing process, impregnating process or the like thereto; sheets containing rubber component, for example, dienes such as styrene-butadiene copolymer, butadiene, non-dienes such as isobutylene-isoprene, chlorinated polyethylene, urethanes, thermoplastics such as thermoplastic elastomer; or combination of at least two thereof. Among these, it is preferable polyolefin resins.

When one or more, preferably all of characteristics of optical transmissivity, melting point, fracture elongation, also absorption coefficient, thickness, lamination condition, fracture strength, specific heat, etching rate, Tg, thermal deflection point, specific gravity, and so forth are taken into account (described below), it is particularly preferable for the base film material to be selected from among materials that will make the workpiece resistant to being cut or adhered to a processing table with a laser beam.

The base film preferably has a thickness of at least 50 µm, more preferably at least 100µm, at least 150µm, about 50 to 1000µm. This facilitates work and operation in the various steps, such as application to a semiconductor wafer, cutting of the semiconductor wafer, and separation from semiconductor chips.

Within the applied range of film thickness, the transmissivity of the base film with respect to the laser beam, and particularly its transmissivity of laser light with a wavelength of from close to 355 nm to close to 600 nm, is at least about 50%, at least about 55%, at least about 60%, at least about 65%, at least about 67%, at least about 70%. The optical transmissivity can be measured using a spectrophotometer for the ultraviolet and visible region. The optical transmissivity of the base film here represents the value in a state of only the base film in which no contact-reducing layer is present.

The base film preferably includes a layer whose melting point is at least 80°C, because this will effectively prevent the base film from being melted by irradiation with the laser beam. Also, melting point of at least 85°C, at least 90°C, at least 95°C, at least 100°C, or at least 110°C is more preferable. If the base film has a single-layer structure, the melting point of that layer itself must be at least 80°C, but if the base film has a laminated structure, not all of the layers necessarily have to have a melting point of at least 80°C, and at least one layer preferably has a melting point of at least 80°C. In this case, that one layer is preferably disposed on the side that will be adjacent side to the contact-reducing layer, more preferably on the side that will be the back side during laser processing (such as the side in contact with the chuck table), that is, it is preferably the one layer is disposed as the contact-reducing layer.

Also, the base film preferably has a multilayer structure of two or more layers of different materials. The phrase "different materials" here encompasses not only materials of different compositions, but also materials whose compositions are the same, but whose characteristics differ because of differences in molecular structure, molecular weight, etc. For instance, it is preferable to laminate materials with one or more different characteristics, such as the above-mentioned absorption coefficient, melting point, fracture strength, fracture elongation, optical transmissivity, specific heat, etching rate, thermal conductivity, Tg, thermal deflection point, pyrolysis temperature, coefficient of linear expansion, or specific gravity.

Of laminate structures with two or more layers, it is especially preferable for at least one layer to be a resin containing no benzene rings or containing a linear saturated hydrocarbon resin, such as a polyolefin resin. Polyolefins include at least one of polyethylene (e.g., low-density polyethylene, liner low-density polyethylene, high-density polyethylene, etc.), polypropylene (e.g., drawn polypropylene, non-drawn polypropylene, etc.), polyethylene copolymer, propylene copolymer, ethylene-propylene copolymer, polybutadiene, polyvinyl alcohol, polymethyl pentene, ethylene- vinyl acetate copolymer, polyvinyl acetate. Among these, ethylene or propylene (co)polymer is preferable, and at least one of polyethylene, polypropylene, ethylene copolymer, propylene copolymer, ethylene-propylene copolymer is more preferable. Selecting one of these materials strikes a good balance between stretchability and adequate strength with respect to laser processing. Also, it is preferable that the contact-reducing layer itself is made of these materials or includes these materials.

When the base film has a laminate structure, it preferably includes both a polyethylene resin layer and a polypropylene resin layer. It is particularly preferable to use a two- or three-layer structure including these layers. In this case, the polypropylene resin layer is preferably disposed farther away from the adhesive layer. For example, in the case of a two-layer structure, it is preferable if the polypropylene resin layer is disposed on the back side of the base film, and the polyethylene resin layer on the adhesive layer side, and in the case of a three-layer structure, it is preferable if the polypropylene resin layer is disposed on the back side of the base film or one layer away toward the adhesive layer, and the polyethylene resin layer on the adhesive layer side. With this construction, even if part of the base film should be damaged during laser processing, suitable stretchability will still be ensured in the base film by the polypropylene resin layer, which is a relatively soft resin and is present on the outermost back side.

It is preferably for the base film to have a fracture elongation of at least 100%. Fracture elongation can be measured, for example, as set forth in JIS K 7127, using a universal tensile tester at a pulling rate of 200 mm/minute. If the base film has a laminated structure, not all of the layers necessarily have to have a fracture elongation of at least 100%, but at least the layer with a fracture elongation of at least 100% is preferably disposed on adjacent to the contact-reducing layer. A layer itself having a fracture elongation of at least 100% may be a layer constituting the contact-reducing layer. After laser dicing has been performed, the dicing sheet can be stretched to easily separate the chips formed by cutting the workpiece.

The base film should have an absorptivity coefficient of no more than 65, and preferably no more than 60, no more than 55, no more than 50, no more than 45, no more than 40. Here, the absorptivity coefficient can be, for example, the absorptivity coefficient α determined by the Beer-Lambert law (I/I₀=exp⁻α^{d}) from the light transmission I/I₀ at a wavelength of 355 nm measured using a Shimadzu Spectrophotometer MPS-2000 and the sample width d. However, the measuring wavelength need not necessarily be 355 nm, but may be about 248 to 1100 nm, and preferably about 248 to 800 nm, about 248 to 600 nm. When the base film is a laminated structure, the absorptivity coefficient of each layer need not necessarily be 65 or less, but the laminated base film as a whole should have an absorptivity coefficient of 65 or less. An absorptivity coefficient of no more than 65 will allow the absorption of laser light by the base film to be kept to a minimum, and can prevent the base film itself from being processed by the laser light.

The base film also preferably has a high specific heat. For instance, the specific heat is preferably at least about 0.5 J/g·K, at least about 0.7 J/g-K, at least about 0.8 J/g·K, at least about 1.0 J/g·K, at least about 1.1 J/g·K, or at least about 1.2 J/g·K. A relatively high specific heat makes it less likely that the base film itself will be heated by the heat generated by the laser beam, and allows part of that heat to escape to outside the base film. As a result, the base film is more resistant to processing, the cutting of the base film is kept to a minimum, and the back side can be prevented from adhering locally to the processing table. The specific heat can be measured as set forth in JIS K 7123. More specifically, it can be found by using a differential scanning calorimeter (DSC) to measure the amount of heat required to raise the temperature of a test piece at 10°C/mm².

Also, the base film preferably includes two or more layers with different fracture strength. The fracture strength here can be measured as set forth in JIS K 7127, using a universal tensile tester at a pulling rate of 200 mm/minute. There are no particular restrictions on the difference in the fracture strength, but about 20 MPa or more is suitable, for example, and about 50 MPa or more is preferable. In this case, it is preferable if the layer with the greater fracture strength is disposed farther away from the adhesive layer. In other words, the layer that is stronger and less likely to be cut by the laser beam is preferably disposed on the back side of the base film. However, it is suitable the fracture strength of about 150 MPa or less, about 120 MPa or less, 100 MPa or less because there will be apprehension of crippling stretchability if Young's modulus (initial modulus of elasticity) is too large.

Furthermore, the base film preferably has a low etching rate. For instance, the etching rate is preferably from about 0.3 to 1.5 µm/pulse, from about 0.3 to 1.2 µm/pulse or from about 0.3 to 1.1 µm/pulse at a laser beam intensity of about 1 to 5 J/cm . In particular, the etching rate is preferably at most about 0.9 µm/pulse, at most about 0.8 µm/pulse or at most about 0.7 µm/pulse at a laser beam intensity of about 1 to 2 J/cm². A lower etching rate prevents the base film itself from being cut.

It is preferable for the base film to have a glass transition point (Tg) of at most about 50°C, at most about 30°C, at most about 20°C, at most about 0°C, or a thermal deflection temperature of at most about 200°C, at most about 190°C, at most about 180°C, at most about 170°C, or a specific gravity of at most about 1.4 g/cm³, at most about 1.3 g/cm³, at most about 1.2 g/cm³, at most about 1.0 g/cm³. Having the above characteristics is advantageous in that it allows the cutting of the base film to be kept to a minimum and prevents the back side form locally adhering to the processing table. The Tg and the thermal deflection temperature can be measured, for example, by a standard method for measuring the transition temperature of a plastic as set forth in JIS K 7121 (more specifically, they can be measured by using differential thermal analysis (DTA), differential scanning calorimetry (DSC) or the like). In particular, the thermal deflection temperature may be measured according to the method in JIS K 7112, as softening initiation temperature. Specific gravity can be measured by a commonly known method for measuring the density (specific gravity) of a plastic as set forth in JIS K 7112 (more specifically, underwater replacement, pycnometry, sink-and-float analysis, a density gradient method, etc.).

In order to improve the supportability, adhesion with adjacent materials of the table and so forth in the processing apparatus, and so on of the surface of the base film, this surface may be subjected, for example, to a chromate treatment, ozone exposure, flame exposure, high-voltage electrical shock exposure, ionizing radiation treatment, or other such chemical or physical treatment, or to coating with a primer (such as the adhesive discussed below), or another such known surface treatment.

There are no particular restrictions on the adhesive layer formed on the adhesive sheet for laser processing of the present invention, but it can be formed, for example, by using an adhesive composition that is known in this field and that contains a thermosetting resin, thermoplastic resin, energy radiation-curing resin (that is cured by radiation with UV rays, an electron beam, or the like) or the like. The use of an energy radiation-curing resin is particularly preferable because it improves the release characteristics of the workpiece. This is because irradiation lowers the adhesive strength to form a three-dimensional reticulated structure within the adhesive, and facilitates release characteristics after use. There are no particular restrictions on the adhesive, but it can be used for the adhesive described in, for example, JP-2002-203816-A, JP2003-142433-A, JP2005-19607-A, JP2005-279698-A, JP2006-35277-A, JP2006-111659-A and the like.

More specifically, examples include natural rubber, various kinds of synthetic rubber, and other such rubbers, and compounds containing an acrylic polymer such as an alkyl poly(meth)acrylate manufactured from acrylonitrile and an alkyl acrylate or alkyl polymethacrylate having linear or branched alkyl groups with about 1 to 20 carbons.

A multifunctional monomer can be added into the adhesive as a crosslinking agent. Examples of the crosslinking agent include hexandiol di(meth)acrylate, (poly)ethylene glycol di(meth)acrylate, urethane acrylate and the like. The crosslinking agent can be used alone or as a mixture of more than two compounds.

To obtain an energy radiation-curing adhesive, a monomer or oligomer that readily reacts under optical irradiation, which is known as a photopolymerizable compound, is preferably combined. Examples of these include urethane, methacrylate, trimethyl propane trimethacrylate, tetramethylol methane tetramethacrylate, 4-butylene glycol dimethacrylate and the like.

Moreover, in this case, a photopolymerization initiator may be also included. Examples of the initiator include acetophenone compounds such as 4-(4-hydroxyethoxy) phenyl(2-hydroxy-2-propyl)ketone, benzoine ether compounds such as benzoine ethyl ether, ketal compounds, aromatic sulfonyl chloride compounds, light-active oxime compounds and benzophenone compounds. These compounds can be used alone or as mixtures thereof.

To obtain a thermosensitive adhesive, what is known as a thermofoaming component (decomposition type or microcapsule type) may be used. See European Patent 0523505, for example.
The adhesive may further comprise any appropriate additive such as tackifiers, fillers, pigments, anti-aging agents or stabilizers, softening agents incorporated therein, if necessary.
There are no particular restrictions on the thickness of the adhesive layer, but about 300 µm or less, or a range of about 3 µm to 200 µm, for example, is preferable with taking into account obtaining sufficient strength and not leaving any undesirable adhesive residue behind after the adhesive sheet has been removed from the semiconductor wafer or the like.

The adhesive sheet for laser processing of the present invention can be formed by any known method in this field. For example, as discussed above, an adhesive component is prepared, this is used to coat the base film, and the coating is dried. Any of various methods can be employed to apply the adhesive component coating methods such as bar coator coating, air knife coating, gravure coating, gravure reverse coating, reverse roll coating, rip coating, die coating, dip coating, offset printing, flexographic printing, screen printing and other industrially applied coating methods may be used.. Another example of a method that can be employed is to separately form an adhesive layer on a stripping liner, and then affix this to the base film.

The adhesive sheet for laser processing of the present invention is preferably used for processing utilized laser light. The laser light includes one with an oscillation wavelength less than 400 nm, such as a third or fourth harmonic of a YAG laser with an oscillation wavelength of 355 nm or 266 nm, XeCI excimer laser with an oscillation wavelength of 308 nm, or KrF excimer laser with an oscillation wavelength of 248 nm, as well as one with an oscillation wavelength greater than 400 nm, such as a titanium sapphire laser with a wavelength from 750 nm to 800 nm, with pulse width of 1 e⁻⁹ second or less.

The adhesive sheet for laser processing of the present invention can be applied to semiconductor wafers (such as silicon wafer, germanium wafer, gallium arsenide wafer), circuit boards, ceramic substrates, metal substrates, substrates for light-emitting diode (e.g. semiconductor laser) and photoreceptor, substrates for MEMS (micro electro mechanical system), semiconductor packages and the like. That is, the adhesive sheet is, for example, prior to dicing with a laser beam, used to applied on the processing table in the dicing apparatus side of the semiconductor wafer, and during its cutting and in a subsequent step, to support and fix individual chips that have been separated.

The area of the base film in contact with the processing table is lower in the adhesive sheet for the invention, thus minimizing adhesion of the back side of the base film to parts of the processing table in the dicing device, even if parts of the base film melt in the part that is irradiated by the laser light during this type of use, and since gaps can be effectively introduced between the contact-reducing layer and the processing table, some of the energy from the laser light can pass through the gaps and effectively escape from the base film, allowing less of the base film to be melted. Furthermore, the adhesive layer or some of the base film and the adhesive layer are cut along with the semiconductor wafer or the like, but the base film on the processing table surface side is more difficult to cut, preventing fragmented chips or the like from being scattered or falling off.

### Example 1

### (Preparation of Adhesive solution)

100 weight parts acrylic polymer having number-average molecular weight of 500000 and copolymerized by butyl acrylate/ ethyl acrylate/ 2-hydroxy ethyl acrylate/acrylic acid at weight ratio of 60/40/4/1, 3 weight parts isocyanate crosslink agent (Coronate HL, made by Nippon Polyurethane Industry Co., Ltd.), 2 weight parts epoxy crosslink agent (Tetrad C, made by Mitsubishi Gas Chemical) was added to 500 weight parts toluene and uniformly dissolved and mixed to prepare an acrylic adhesive solution (1).

### (Production of Adhesive Sheet for Laser Processing having Contact-Reducing Layer)

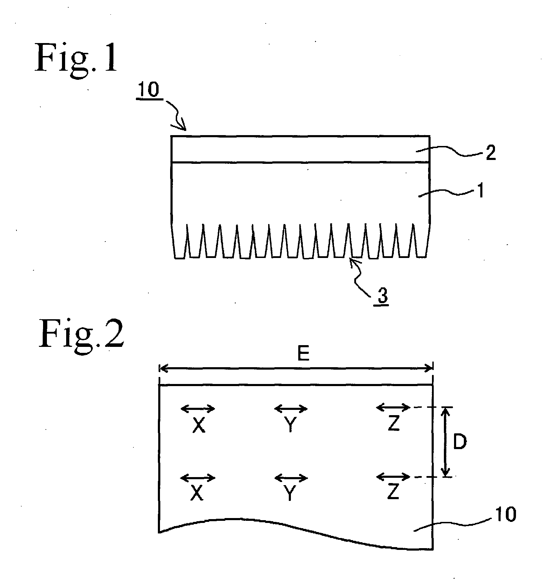

A hot machining rolls having machined depth of 1.0 µm, 3.0 µm, 5.0 µm, or 10 µm (Yuri Roll Machine Co.) and a mirror finish roll were used to form contact-reducing layers on one side of 150 µm thick polyethylene films (melting point: 115°C) having a light transmittance of about 66% to 355 nm light (referred to below as "embossing process").
The arithmetical mean deviation of the surface Ra of the resulting polyethylene films was measured. As the results in Table 1 reveal, polyethylene films with 1.2 µm, 2.9 µm, 5.0 µm, 10.3 µm contact-reducing layers were obtained, respectively.
To improve the adhesion with the adhesive, a corona discharge treatment was carried out on the surface of the polyethylene films on the side opposite the side having the contact-reducing layer. An acrylic adhesive was then applied to a thickness of 20 µm, producing adhesive sheets for laser processing 10 with the adhesive layer 2 formed on the surface of the base film 1 and the contact-reducing layer 3 formed on the back side, as shown in Fig 1.

### (Measurement of Surface Roughness)

A P-15 device by Tencor for measuring differences in levels/surface roughness microformation was used to determine the arithmetical mean deviation of the surface Ra from the mean roughness measured in a total of 30 locations on the contact-reducing layer surface of the resulting adhesive sheet for laser processing, comprising 10 longitudinal locations at intervals D (such as 10 m) in 3 locations in the widthwise direction of the adhesive sheet for laser processing 10 (for example, width E = 1400 mm). The surface of the contact-reducing layer was measured for a length of 50 mm in each location.

### (Measurement of Adhesive Strength with Chuck Table)

As shown in Fig. 1, the adhesive sheet for laser processing was disposed on a quartz glass table as a chuck table of a laser dicing apparatus using a ling for fixing 11, so as to contact with the side of the contact-reducing layer.
A third harmonic (355 nm) of a YAG laser with a wavelength of 355 nm as a processing laser, an average output of 5 W, and a repeated frequency of 30 kHz was used. The laser light was focused with an fθ lens on the surface of the adhesive sheet for laser processing, and was scanned with a galvano scanner at a rate of 20 mm/second to cut the sheet.

To more clearly check the adhesion tendency of each adhesive sheets for laser processing on the chuck table, the adhesion strength was measured by varying the number of scans to between 1 and 8 times.
The adhesive strength between the adhesive sheet for laser processing and the chuck table was measured according to the JIS Z0237 adhesive strength measurement method. That is, as the test piece, a laser processed adhesive sheet for laser processing 10 was cut to a width A of 20 mm and a length B of 150 mm, and the tension tester stipulated in JIS B7721 was used as the measurement device to measure the load (adhesive strength, N/20 mm) when separated at a measuring temperature of 23 ± 3°C, a release angle of 180°, and a release speed of 300 mm/sec.

### Comparative Example

A 150 µm thick polyethylene film was formed using 2 mirror metal rolls, without any hot machining roll having a machined depth, giving a polyethylene film without a contact-reducing layer.
Measurement of the arithmetical mean deviation of the surface Ra on both sides of the film revealed a value of 0.4 µm on both sides, as indicated in Table 1.

**Table 1**

| Processing Depth | Ra [µm] | Numbers of Scanning | | | | | | | |
|---|---|---|---|---|---|---|---|---|---|
| | | 1 | 2 | 3 | 4 | 5 | 6 | 7 | 8 |
| 1.0µm | 1.2 | 1.4 | 1.6 | 2.1 | 2.9 | 3.4 | 4.7 | 5.3 | 5.9 |
| 3.0µm | 2.9 | 1.2 | 1.4 | 1.8 | 1.9 | 2.1 | 2.3 | 2.9 | 3.3 |
| 5.0µm | 5.0 | 0.7 | 0.9 | 1.1 | 1.6 | 1.8 | 1.9 | 2.0 | 2.4 |
| 10µm | 10.3 | 0.3 | 0.4 | 0.4 | 0.5 | 0.7 | 0.8 | 0.8 | 0.9 |
| Mirror Metal Roll | 0.4 | 2.5 | 3.2 | 3.8 | 5.7 | 7.9* | 9.0* | 11. 0* | 12.0* |

| | | | | | | | | | |
|---|---|---|---|---|---|---|---|---|---|
| *: Failure of Peeling-off | | | | | | | | | |

### Example 2

An embossing process, formation of the contact-reducing layer, and an evaluation were conducted in the same manner as in Example 1, except that A polypropylene/polyethylene/ polypropylene composite film (film thickness: 30µm/90 µm/30gm, melting point: 130°C, a light transmittance of 70% to 355 nm light) was used as the base film.
Although the adhesive sheet for laser processing was cut to some extent during multiple laser scanning times, virtually the same results as above were obtained in terms of the adhesion of the adhesive sheet for laser processing to the chuck table.

The examples and comparative examples thus clearly show that the adhesive sheet for laser processing of the invention can be used to reduce the adhesion on the chuck table during laser processing, and can be readily conveyed to subsequent processes (such as washing and pick up) after laser processing.
This application claims priority to Japanese Patent Application No. 2006-272862. The entire disclosure of Japanese Patent Application No. 2006-272862 is hereby incorporated herein by reference.
While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

## Claims

1. An adhesive sheet for laser processing, comprising an adhesive layer laminated on the surface of a base film,
wherein the base film has a textured contact-reducing layer on the back side thereof.

2. The adhesive sheet according to Claim 1, wherein the contact-reducing layer provides the outer surface on the back side of the base film with a texture having a arithmetical mean deviation of the surface Ra of at least 1.0 µm.

3. The adhesive sheet according to Claim 1, wherein the base film has the transmissivity of at least 50%.

4. The adhesive sheet according to Claim 1, wherein the base film comprises at least one layer containing a polyolefin resin.

5. The adhesive sheet according to Claim 1, wherein the polyolefin resin is at least one resin selected from the group consisting of polyethylene, polypropylene, polyethylene copolymer, propylene copolymer, ethylene-propylene copolymer.

6. The adhesive sheet according to Claim 1, wherein the base film comprises a layer having a melting point of at least 80°C.

7. The adhesive sheet according to Claim 1, wherein the base film includes at least two layers with different fracture elongation, and the layer with the greater fracture elongation is disposed adjacent to the contact-reducing layer.

8. The adhesive sheet according to Claim 1, wherein the layer with the greater fracture elongation has a fracture elongation of at least 100%.

9. The adhesive sheet according to Claim 1, wherein the contact-reducing layer is formed by sand blasting, embossing process or surface coating.
